# EUROPEAN PATENT APPLICATION

(11) **EP 1 475 864 A2**
(43) Date of publication of application: **10.11.2004**
(21) Application number: 04101469.7
(22) Date of filing: 08.04.2004
(51) Int. Cl.: H01R 35/02

(54) **Hinge and pivot mechanism with electrical connection**

(30) Priority: 06.05.2003 KR 2003028617
(71) Applicant: Samsung Electronics Co., Ltd., Suwon-si, Gyeonggi-Do 442-742 (KR)
(72) Inventor: Ahn, Kyoung-jin 504-303, Sinnamusil Jugong Apt504-, Gyeonggi-do (KR)
(74) Representative: Read, Matthew Charles

(57) **Abstract**

A hinge apparatus, which includes a first hinge part connected, in a rotatable manner, to a first electronic apparatus, a second hinge part having a second hinge axis connected in an inclined manner at a predetermined angle to a first hinge axis of the first hinge part, a wiring member for connecting the first and the second electronic apparatus by sequentially passing by the first and the second hinge axes in a manner of winding around the outer peripheral surfaces of each of the first and the second hinge axes. Accordingly, the hinge apparatus can connect a plurality of electronic apparatus so that those electronic apparatus are mutually rotatable in a plurality of rotational directions without implementing the complicated manufacturing process of forming through holes on each of the hinge axes, and inserting the wiring member into those through holes.

## Description

The present invention relates to a hinge and pivot mechanism comprising first, second and third elements and a signal lead through the mechanism, the first and second elements being hinged together to provide a first degree of rotational movement between the first and second elements and the third element being pivotably coupled to the second element to provide a second degree of rotational movement between the first and second element.

It is known to mount a display, e.g. an LCD, to the body of a small electronic apparatus, e.g. a PDA, a camera, a mobile phone, a notebook computer, a audio and/or video player or a games console. The display can thus be rotated for opening and closing and for viewing from different angles.

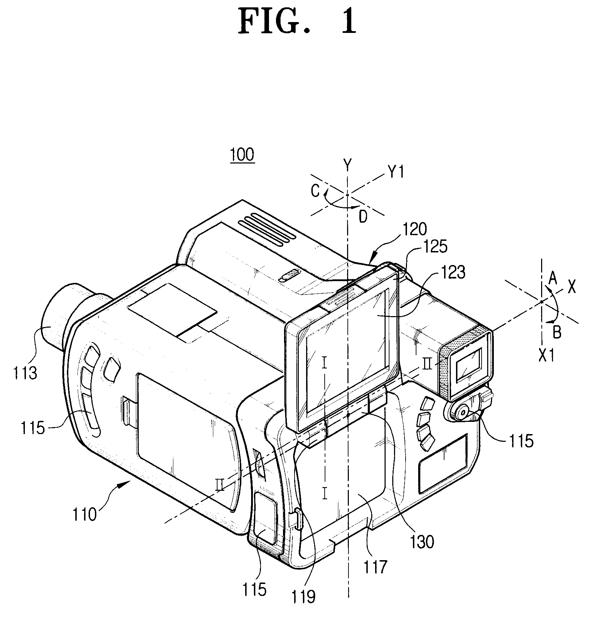

Figure 1 is an exemplary illustration of a multi-function camera apparatus 100 which combines the functions of a digital still camera and a camcorder in one unit.

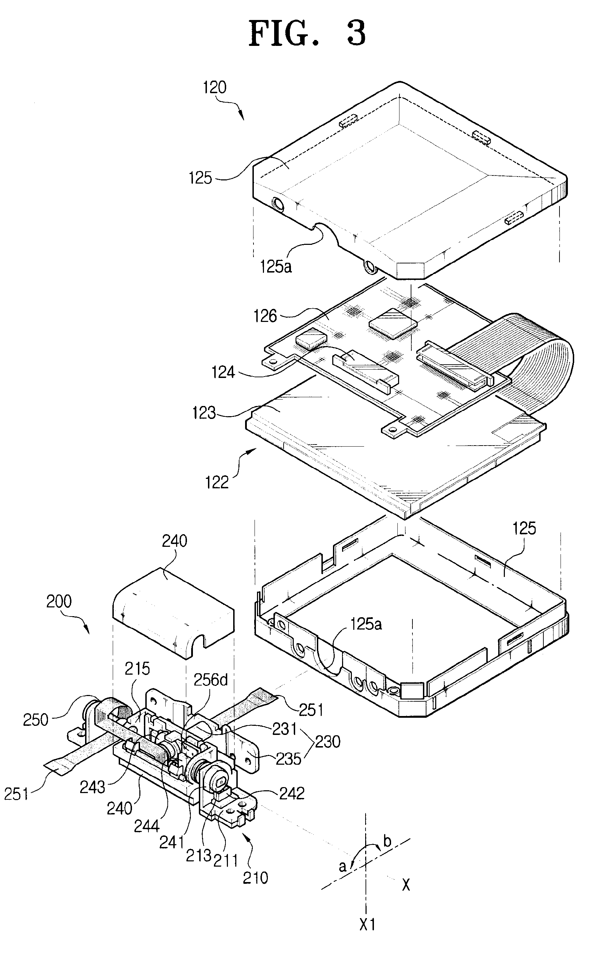

Referring to Figure 1, the multifunction camera apparatus 100 includes a portable apparatus body 110 and a display unit 120 connected in a rotatable manner, to one side of the main body 110, by a hinge 130. The main body 110 includes an optical unit 113 for capturing images and an operating button 115. The display unit 120 includes an electronic subsystem 122 (refer to Figure 3) and a casing 125 enclosing the electronic subsystem 122. The electronic subsystem 122 comprises a display panel 123 for playing an image and a circuit board 126 (refer to Figure 3).

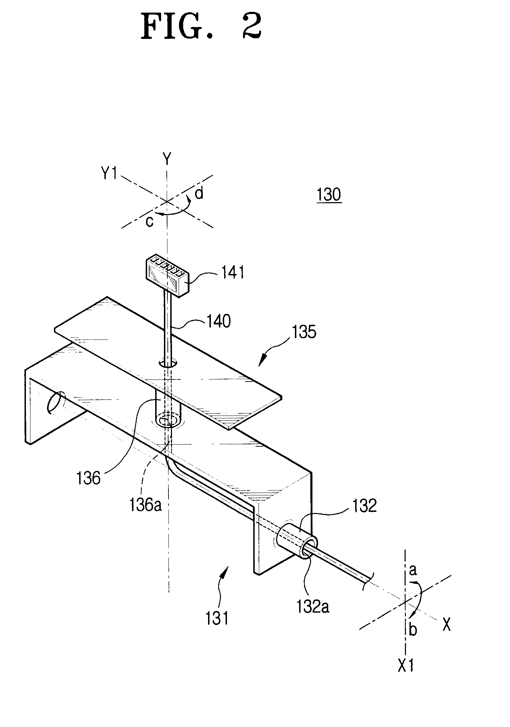

Figure 2 is an exemplary illustration of a conventional hinge for connecting a display unit 120 to a main body 110 of an apparatus, so that the display unit 120 can be rotated around two axes X, Y.

Referring to Figure 2, the conventional hinge 130 includes the first hinge part 131 that is rotatably connected to a rear edge of the main body 110 (refer to Figure 1), a second hinge part 135 that is fixed to one side of the display unit 120 (refer to Figure 1) and rotatably connected to the first hinge part 131. Additionally, a lead 140 is threaded through the hinge 130 and has a connector 141 at one end for connecting to the electronic subsystem 122 in the display unit 120.

The first hinge part 131 enables the display unit 120 to rotate relative to the main body 110 in directions "a" and "b" for opening and closing respectively. The second hinge part 135 enables the display unit 120 to rotate relative to the main body 110 in directions "c" and "d".

When not in use, the display unit 120 is located in a recess 117 on the back of the apparatus and rotating it from this position in direction "a" reveals the display panel 123.

With the configuration described above, the lead 140 must be passed through holes 132a, 136a that are coaxial with the hinge axes X, Y. should be formed on the first and the second hinge axes 132, 136, respectively, in order to connect the display unit 12 to the main body 110 so that signal transfer may be mutually possible.

However, the capacity of the lead 140 is limited because making the lead 140 thicker to accommodate more signal paths means that the hinge 130 must be more bulky to avoid damage to the lead 140 or interference with the hinge's operation by the lead 140.

A hinge and pivot mechanism, according to the present invention, is characterised in that the signal lead is arranged so as to be wound around the axis about which the second element can be rotated relative to the first element and the axis about which the third element can be pivoted relative to the second element.

The pivoting of the third element with respect to the second element may consists of twisting the third element with respect to the second element, in which case a shaft may connect the second and third elements so as to be coaxial with the axis about which the third element can be pivoted relative to the second element with the signal lead wound around the shaft.

An axel axle may connect the first and second elements so as to be coaxial with axis about which the second element can be rotated relative to the first element with the signal lead wound around the shaft. The axel may be one of a pair of axially aligned stub axels connecting the first element to the second element.

The lead may comprise a ribbon-like structure, e.g. a flexible substrate having conductive tracks formed thereon.

According to the present invention, there is also provided an electronic apparatus having first and second parts connected by a mechanism according to the present invention. The second part may include a display device and/or the first part may include image sensing means.

Additional preferred and optional features of the present invention are set forth in claims 11 to 33 appended hereto.

Embodiment of the present invention will now be described, by way of example, with reference to the accompanying drawings, in which:
Figure 1 is a perspective view of a multifunction camera;
Figure 2 is a perspective view illustrating the structure of a hinge used for the display unit of the camera shown in Figure 1;
Figure 3 is a perspective view illustrating a display unit of a portable electronic apparatus and the structure of a hinge used for the display unit;
Figure 4 is a perspective view of the hinge shown in Figure 3;
Figure 5 is plan view of a first wiring member according to the present invention;
Figure 6 is a perspective view illustrating the wiring member of Figure 5 as it is mounted in a hinge;
Figure 7 is a plan view illustrating a second wiring member according to the present invention; and
Figure 8 is a perspective view illustrating a the wiring member of Figure 6 as it is mounted in a hinge.

In the description of the embodiment of the present invention, same drawing reference numerals are used for the elements having the same construction and function as the elements of the conventional portable electronic apparatus shown and described in Figure 1 and Figure 2, and description thereof will be omitted.

In an embodiment of the present invention, a hinge connects different components of an electronic apparatus so that one of the components is rotatable with two degrees of freedom with respect to the other components.

Referring to Figures 3 and. 4, a hinge 200 for connecting the display unit 120 with the main body 110 (shown in Figure 1). The main body 110 is an example of the component, as mentioned above, and the display unit 120 is an example of another component, as mentioned above..

The hinge 200 includes a first hinge part 210, a second hinge part 230, a wiring member 250 and a cover 240. The hinge also comprises a first protuberance 241, a first sensor 242, a second protuberance 243 and a second sensor 244. The sensor 242, 244 detect the positions of respective ones of the protuberances 241, 243 to signal the orientation of the display unit 120 relative to the main body 110 to enable the image to be flipped vertically so that it does not appear upside down to the user when certain display unit configurations are adopted..

The first hinge part 210 enables the display unit 120 to be rotated in the first and the second directions "a" and "b" for opening and closing the display unit 120. The first hinge part 210 includes a first fixing members 211 on either side and fixed on the inside of the main body 110, a pair of axially aligned stub axles 213, projecting towards each other from respective first fixing members 211, and a rotary member 215 connected between the stub axels 213. For reference, the first and the second directions "a" and "b" have, as the centre of rotation, a virtual X-axis extending along the primary axes of the stub axels 213.

The second hinge part 230 is used to rotate the display unit 120 in the third and fourth directions "c" and "d" after the display unit 120 is freed from the reception part 117 (see Figure 1). In order to rotate the display unit 120 in this manner, the second hinge part 230 includes a shaft 231 rotatably mounted to the rotary member 215. For reference, the third and the fourth directions "c" and "d" have, as their centre of rotation, an axis Y that always lies in a plane perpendicular to the X-axis.

The wiring member 250 electrically connects the display unit 120 to the main body 110 so that electrical signals can be transferred between them. The wiring member 250 extends from the display unit 120 in to the main body 110 by first passing through the shaft 231 and then around one of the stub axels 213.

The cover 240 encloses the first and the second hinge parts 210, 230 and the portion of wiring member 250 exposed between the display unit 120 and the main body 110 when the display unit 120 connected to the main body 110.

The wiring member 250 is wound around one of the stub axels 213 and the shaft 231 and does not pass through either of the stub axels 213 or the shaft 231.

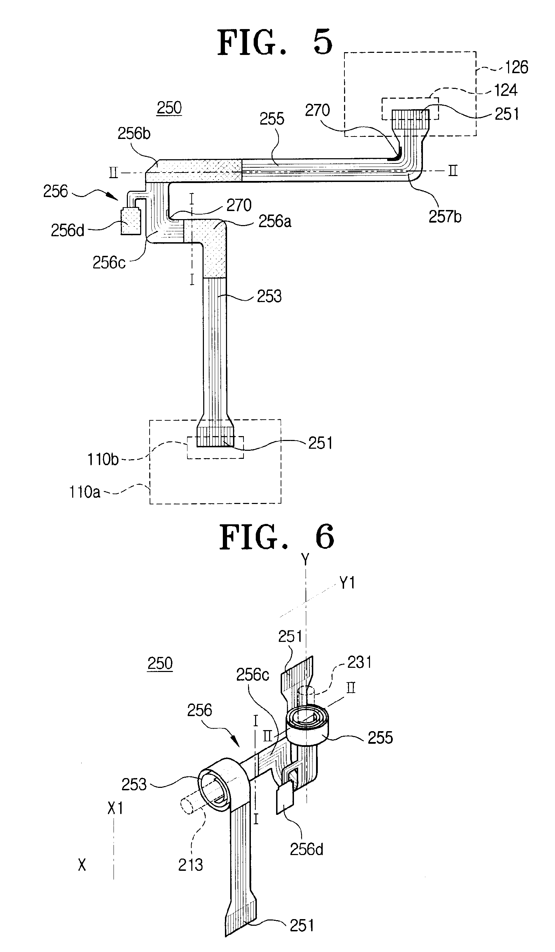

The wiring member 250 is a printed metal pattern with connectors 251 formed integrally at either end which are received by the first and the second connectors 110b, 124 (shown in Figure 5) respectively. The hinge 200 uses a flexible printed circuit (FPC) that can be freely bent for the wiring member 250. The ends of the wiring member 250 extend from the inside of the cover 240 into respectively the display unit 120 and the main body 110. The wiring member 250 passes through a connecting hole 125a formed on the casing 125 of the display unit 120 and a connecting hole (not shown) prepared on the connecting part 119 (refer to Figure 1) of the main body 110. Since the cover 240 encloses the hinge 200, the wiring member 250 is not exposed between the display unit 120 and the main body 110.

Referring to Figures 5 and 6, the wiring member 250 of a first embodiment includes a first winding part 253 which is winding around one of the stub axels 213, a second winding part 255 which is wound around the shaft 231 and an L-shaped connecting part 256 connecting the first and the second winding parts 253, 255. The connecting part 256 has a first corner part 256a connected to the first winding part 253 at one end and a second corner part 256b connected to the second winding part 255 at its other end. The connecting part 256 also includes a third corner part 256c connecting the first and the second corner parts 256a, 256b. The third corner part 256c can be omitted in other embodiments. A third connector 256d is located at the end of a small L-shaped branch projecting from the side of the connecting part 256 between the first and the second corner parts 256a, 256b. The third connector 256d is connected to a first sensor 244 (shown in Figure 3). The first sensor 244 provides a signal indicating the orientation of the display unit 120 relative to the main body 110 so that the displayed image can be inverted relative to the display unit 120 to keep it the correct way up from the user's perspective.

Referring to Figure 6, a portion of the wiring member 250 is coated with a coating material. This coating material prevents the wiring member 250 from being damaged or degraded by contact with the main body 110, the cover 240 or the display unit 120, as the display unit 120 is repositioned with respect to the main body 110. The portions of the wiring member 250 that are positioned in the gaps (I-I, II-II) between the main body 110, the cover 240 and the display unit 120 are difficult to see from the outside of the portable apparatus 100. A black film made of a resin is preferably used for the coating material.

The hinge 200 is configured so that the display unit 120 can be rotated in the first through the fourth rotational directions "a", ..., "d" through predetermined angular ranges. Restricting rotation to specific predetermined angular ranges prevents the wiring member 250 from being twisted and spoiled due to excessive rotation of the display unit 120 in one direction. Therefore, the rotational range of the display unit 120 by the hinge 200 with respect to the main body 110 is determined by a restricting means.

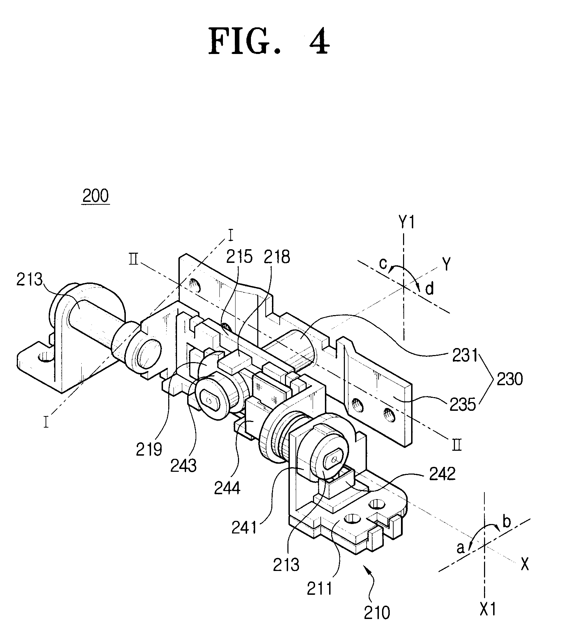

Referring to Figure 4 again, the rotational range of the display unit 120 is restricted by the hinge 200 so that the angular range of movement of the display unit 120 in directions "a" and "b" is restricted to about 180°, i.e. between fully closed and fully open positions as shown in Figure 1. Similarly, angular range of movement in directions "c" and "d" is also restricted to about 180°.

The angular range of movement in the first and second directions "a" and "b" is determined by display unit 120 being fully received in the recess 117 at one extreme and the display unit 120 contacting an upper back part of the main body 110 at the other extreme. The rotational range restriction for the third and the fourth directions "c" and "d" is determined by contact between a tab 218 (shown in Figure 4) projecting from the underside of the rotary member 215 and a flange 219 projecting radially from the shaft 231 and which rotates therewith.

The rotational range restriction of the display unit 120 determines the minimum lengths of the first and the second winding parts 253, 255 for winding around the first and the second hinge axes 213, 231, respectively. As the rotational range of the display unit 120 increases the minimum lengths of the first and the second winding parts 253, 255 also increases. This prevents the wiring member 250 from being damaged or degraded by winding/unwinding of the first and the second winding parts 253, 255 upon rotation of the display unit 120. Since the display unit 120 is restricted from rotating beyond about 180° any direction, the first and the second winding parts 253, 255 are formed of such a length that the wiring member 250 can wind around the first and the second hinge axes 213, 231 more than about 1.5 turns. Therefore, twisting of, and subsequent damage to, the wiring member 250 is prevented while the display unit 120 is rotated in the first through the fourth rotational directions "a", ..., "d".

If winding parts 253, 255 are formed in such a length that they can wind around each of the hinge axes 213, 231 several times, rotation of the display unit 120 is easily performed and space for winding/unwinding is minimized. The length of the respective winding parts 253, 255, however, cannot be made too long, as the volume of the hinge 200 would become large due to the thickness of the winding parts 253, 255 wound around one of the stub axels 213 and the shaft 231. It would then be difficult to provide the compact electronic apparatus (i.e., multifunction camera apparatus 100) if the lengths of the winding parts 253, 255 were unnecessarily long. Therefore, the lengths of the first and the second winding parts 253, 255 should be appropriately adjusted within such a range that the volume of the hinge 200 can be minimized in agreement with the predetermined rotational range, and that the winding parts 253, 255 cannot be damaged or degraded upon rotation of the display unit 120. This is particularly so in the case of the second winding part 255 as it is wound around the second hinge axis 231, which is arranged in a space narrower than the first hinge axis 213. In view of these concerns, the second winding part 255 is formed with a length that can wind around the shaft 231 about 3.5 turns. When constructed in this manner, damage to the wiring member 250 is prevented during rotation of the display unit 120 and the volume occupied by the second winding part 255 for winding or unwinding around the outer peripheral surface of the second hinge axis 231 is minimized as well.

Referring back to Figures 5 and 6 again, the connectors 251, which connects the wiring member 250 to the first and the second connectors 110b, 124 of the first and the second boards 110a, 126, are provided, respectively, at the side of the main body 110, in the first winding part 253, and the end at the side of the display unit 120, in the second winding part 255. The positions of the first and second connectors 110b, 124 change the whole shape of the wiring member 250. As shown in Figures 5 and 6, in the case that the first connector 110b is arranged on a virtual first axis (X1-axis) perpendicular to the primary axis (X-axis) of the stub axels 213, the connector 251 is directly arranged on the end of the first winding part 253. In the case that the second connector 124 is arranged on the Y-axis of the second hinge axis 255, the connector 251 is connected to the second winding part 255 in an inclined manner by the fourth corner part 257b.

Preferably, the wiring member 250 having such construction additionally includes a reinforcing member 270. The reinforcing member 270 prevents the fourth corner part 257b from being torn as the second winding part 255 winds around the second hinge axis 231. The reinforcing member 270 is installed in the inside of the fourth corner part 257b and is provided in the form of a metal pattern installed regardless of signal exchange between the first and the second boards 110a, 126. As one skilled in the art can appreciate, any type of reinforcing member whatsoever can be used to prevent shearing stress form tearing the fourth corner part 257b.

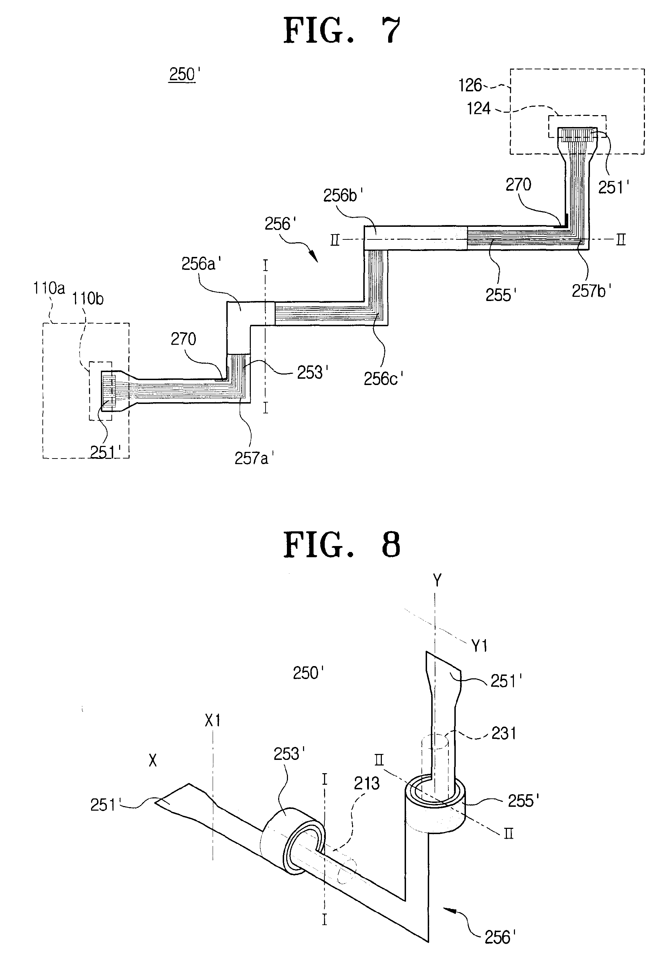

Referring to Figures 7 and 8, the wiring member 250' of a second embodiment is similar to that of the first embodiment in that the wiring member 250' has the first and the second winding parts 253', 255' and a connecting part 256'. The shapes and position of each part of the first and the second winding parts 253', 255', however, are different for the first and the second winding parts 253', 255' in that their lengths differ from the corresponding components of the first embodiment. The first and the second winding parts 253', 255' can be formed with lengths that can be wound around a stub axel 213 and the shaft 231 more than 1.5 turns.

In the second embodiment, the first connector 110b is arranged in the direction of the primary axis of the stub axels 213. Therefore, the wiring member 250' additionally includes a third corner part 257a'. A metal pattern 270 is formed as a reinforcing member on the third corner part 257a' in order to prevent the third corner part 257a' from being damaged or degraded due to shearing stress as in the case of the fourth corner part 257b of the first embodiment, described above. The shapes of the third and the fourth corner parts 257b' can change in various ways depending on the positions of the first and the second connectors 100b, 124.

In the above description the hinge apparatus has been described for use only in the composite multifunction camera apparatus 100 which is both a camcorder and a digital still camera. The hinge apparatus can be used in the display unit of the portable apparatus. The description of the present invention, however, is not necessarily limited to that specific case. For example, the present invention can also be readily applied to other kinds of portable electronic apparatus that includes a display unit rotatable in a plurality of directions, such as a portable phone, a PDA, a notebook computer, and other portable electronic devices..

A hinge apparatus and wiring member constructed in accordance with the embodiments of the present invention as described above, can connect the display unit 120 with the main body 110 so that the wiring member 250, 250' is not exposed to the outside. This accomplished without even requiring the complicated process of forming through holes on a central portion of each hinge axis, and inserting the wiring member 250, 250' into those through holes.

As FPC is used for the wiring member 250, 250', the particular problem of the prior art that the connector should be separately installed on the end of the wiring member is resolved and the rotational range of the display unit can be extended without damaging of the wiring member.

## Claims

1. A hinge and pivot mechanism comprising first, second and third elements (210, 215, 235) and a signal lead (250) through the mechanism, the first and second elements (210, 215) being hinged together to provide a first degree of rotational movement ("a", "b") between the first and second elements (210, 215) and the third element (235) being pivotably coupled to the second element to provide a second degree of rotational movement between the first and second element (210, 235), **characterised in that** the signal lead (250) is arranged so as to be wound around the axis (X) about which the second element (215) can be rotated relative to the first element (210) and the axis (Y) about which the third element (235) can be pivoted relative to the second element (215).

2. A mechanism according to claim 1, wherein said pivoting of the third element (235) with respect to the second element (235) consists of twisting the third element (235) with respect to the second element (235).

3. A mechanism according to claim 2, including a shaft (231) connecting the second and third elements (215, 235) which is coaxial with the axis (Y) about which the third element (235) can be pivoted relative to the second element (215), wherein the signal lead (250) is wound around the shaft (231).

4. A mechanism according to claim 1, 2 or 3, including an axel (213) connecting the first and second elements (210, 215), which is coaxial with axis (X) about which the second element (215) can be rotated relative to the first element (210), wherein the signal lead (250) is wound around the shaft (213).

5. A mechanism according to claim 4, wherein said axel (213) is one of a pair of axially aligned stub axels (213) connecting the first element (210) to the second element (215).

6. A mechanism according to any preceding claim, wherein the lead (250) comprises a ribbon-like structure.

7. A mechanism according to claim 6, where the ribbon-like structure comprises a flexible substrate having conductive tracks formed thereon.

8. An electronic apparatus having first and second parts (110, 120) connected by a mechanism (130) according to any preceding claim.

9. An apparatus according to claim 8, wherein the second part (120) includes a display device (123).

10. An apparatus according to claim 9, wherein the first part (110) include image sensing means (113).

11. A wiring member for electrically coupling a first and second electronic apparatus together, the first and second electronic apparatus comprising a portable apparatus body and a display unit, respectively, wherein the first and second electronic apparatus are connected by a hinge apparatus, the hinge apparatus comprising a first hinge part connected, in a rotatable manner, to the first electronic apparatus, a second hinge part having a second hinge axis connected at a predetermined angle to a first hinge axis of the first hinge part, wherein the wiring member comprising:
a first winding part, for winding around an outer peripheral surface of the first hinge axis;
a second winding part for winding around an outer peripheral surface of the second hinge axis; and
a connecting part for connecting the first and the second winding parts, to each other.

12. The wiring member according to claim 11, further comprising:
a first wiring member connector connected to the first winding part for connecting to a first connector of a first board mounted on an inside portion of the portable apparatus body; and
a second wiring member connector connected to the second winding part for connecting to a second connector of a second board mounted on an inside portion of the display unit.

13. The wiring member according to claim 11, wherein the connecting part comprises :
a first corner part for connecting to the first winding part on a first end; and
a second corner part for connecting to the second winding part on a second end.

14. The wiring member according to claim 13, wherein the connecting part further comprises:
a fifth corner part for connecting the first and the second corner parts.

15. The wiring member according to claim 13, wherein the connecting part further comprises:
a third connector located on one side of the connecting part 256 between the first and the second corner parts and adapted for connecting to a first detecting sensor of a turning-over unit for turning the display unit.

16. The wiring member according to claim 11, further comprising:
a coating material on a portion of the wiring member for protecting the wiring member from being damaged by contact with the portable apparatus body as the display unit is rotated through at least one or more rotational directions with respect to the portable apparatus body.

17. The wiring member according to claim 11, wherein:
the first and second winding parts are formed of such a length to enable the winding member to wind around the first and second hinge axes at least 1.5 times.

18. The wiring member according to claim 11, wherein:
the second winding part is formed of such a length to enable the second winding part to wind around the second hinge axis at least 3.5 times.

19. The wiring member according to claim 11, further comprising:
a fourth corner part; and
a reinforcing member installed in the inside of the fourth corner part for preventing the fourth corner part from being damaged upon exertion of a shearing stress on the fourth corner part as the second winding part winds around the second hinge axis.

20. The wiring member according to claim 11, further comprising:
a first wiring member connector connected to the first winding part for connecting to a first connector of a first board mounted 110a on an inside portion of the portable apparatus body;
a second wiring member connector connected to the second winding part for connecting to a second connector of a second board mounted on an inside portion of the display unit; and
a third corner part for aligning the first wiring member connector in the direction of a primary axis of the first hinge axis.

21. The wiring member according to claim 20, further comprising:
a metal pattern installed on the third corner part for preventing the third corner part from being damaged upon exertion of a shearing stress on the fourth corner part as the second winding part winds around the second hinge axis.

22. A hinge apparatus comprising:
a first hinge part connected, in a rotatable manner, to a first electronic apparatus, a second hinge part having a second hinge axis connected at a predetermined angle to a first hinge axis of the first hinge part; and
a wiring member for connecting the first and the second electronic apparatus by sequentially passing by the first and the second hinge axes in a manner of winding around the outer peripheral surfaces of each of the first and the second hinge axes.

23. The hinge apparatus according to claim 22, wherein the wiring member comprises:
a first winding part, for winding around an outer peripheral surface of the first hinge axis;
a second winding part for winding around an outer peripheral surface of the second hinge axis; and
a connecting part for connecting the first and the second winding parts to each other.

24. The hinge apparatus according to claim 22, further comprising:
a first wiring member connector connected to the first winding part for connecting to a first connector of a first board mounted 110a on an inside portion of the portable apparatus body; and
a second wiring member connector connected to the second winding part for connecting to a second connector of a second board mounted on an inside portion of the display unit.

25. The hinge apparatus according to claim 22, wherein the connecting part comprises :
a first corner part for connecting to the first winding part on a first end; and a second corner part for connecting to the second winding part on a second end.

26. The hinge apparatus according to claim 25, wherein the connecting part further comprises:
a fifth corner part for connecting the first and the second corner parts, in an inclined manner.

27. The hinge apparatus according to claim 25, wherein the connecting part further comprises:
a third connector located on one side of the connecting part between the first and the second corner parts so that the third connector can be connected to a first detecting sensor that is part of a turning-over unit for turning over, upside down, an image displayed on the display unit.

28. The hinge apparatus according to claim 22, further comprising:
a known coating material to coat a portion of the wiring member for preventing the wiring member from being damaged or degraded by contact with the portable apparatus body and the display unit, as the display unit is rotated through at least one or more rotational directions with respect to the portable apparatus body.

29. The hinge apparatus according to claim 22, wherein:
the first and second winding parts are formed of such a length that the winding member can wind around the first and second hinge axes at least 1.5 times.

30. The hinge apparatus according to claim 22, wherein:
the second winding part is formed of such a length that the second winding part can wind around the second hinge axis at least 3.5 times.

31. The hinge apparatus according to claim 22, further comprising:
a fourth corner part; and
a reinforcing member installed in the inside of the fourth corner part for preventing the fourth corner part from being torn out upon exertion of a shearing stress on the fourth corner part as the second winding part winds around the second hinge axis, and is provided in the form of a metal pattern.

32. The hinge apparatus according to claim 22, further comprising:
a first wiring member connector connected to the first winding part for connecting to a first connector of a first board mounted 110a on an inside portion of the portable apparatus body;
a second wiring member connector connected to the second winding part for connecting to a second connector of a second board mounted on an inside portion of the display unit; and
a third corner part for aligning the first wiring member connector in the direction of the primary axis of the first hinge axis.

33. The hinge apparatus according to claim 32, further comprising:
a metal pattern installed on the third corner part for preventing the third corner part from being torn out upon exertion of a shearing stress on the fourth corner part as the second winding part winds around the second hinge axis, and is provided in the form of a metal pattern.
